# EUROPEAN PATENT APPLICATION

(11) **EP 4 800 410 A1**
(43) Date of publication of application: **02.09.2026**
(21) Application number: 25864615.7
(22) Date of filing: 28.08.2025
(51) Int. Cl.: G01R 31/396, H01M 10/48

(54) **BATTERY DIAGNOSTIC APPARATUS AND METHOD**

(30) Priority: 31.10.2024 KR 20240152510; 31.10.2024 KR 20240152511
(71) Applicant: LG ENERGY SOLUTION, LTD., Seoul 07335 (KR)
(72) Inventor: KIM, Hye Yeong, Daejeon 34122 (KR); CHOI, Hyun Jun, Daejeon 34122 (KR); KIM, Young Deok, Daejeon 34122 (KR); KIM, Tae Hyeon, Daejeon 34122 (KR)
(74) Representative: Goddar, Heinz J.
(86) International application number: PCT/KR2025/013135
(87) International publication number: WO 2026/095297

(57) **Abstract**

A battery diagnostic device according to an embodiment of the present disclosure may include a memory storing at least one instruction; and at least one processor executing the at least one instruction, and the at least one processor may acquire a set of reference data of a reference battery cell corresponding to each of a plurality of designated temperatures, acquire cell data of a battery cell at a specific temperature, fit each piece of reference data to the cell data such that deviations between each of the pieces of reference data included in the set of reference data and the cell data are minimized, identify first specific reference data included in the set of reference data and corresponding to a smallest deviation among deviations between each of the fitted pieces of reference data and the cell data, and diagnose a state of the battery cell based on a temperature corresponding to the first specific reference data corresponding to the smallest deviation among the plurality of designated temperatures.

## Description

### TECHNICAL FIELD

### Cross-reference to Related Applications

This application claims priority from Korean Patent Application Nos. 10-2024-0152510, filed October 31, 2024, and No. 10-2024-0152511, filed October 31, 2024, the disclosures of which are incorporated by reference herein.

### Technical Field

Embodiments disclosed herein relate to a battery diagnostic device and a method thereof.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. In recent years, the lithium ion batteries have expanded their range of use to power sources for electric vehicles, making the batteries attract attention as a next-generation energy storage medium.

As various electronic devices become widespread due to the Fourth Industrial Revolution, battery usage is rapidly increasing. Batteries are gaining attention as an essential energy source in various fields such as electric vehicles, portable electronic devices, and renewable energy storage systems, and accordingly, the importance of battery state diagnosis technology for improving battery performance and reliability is increasing.

In particular, technology for identifying the temperature of each of battery cells included in a battery unit is being developed. By identifying the temperature of each battery cell, a performance of battery state diagnosis of a battery diagnostic device may be improved. In this way, battery performance optimization may be achieved, and by inspecting battery cells for abnormalities, quality stability of the battery cells may be secured.

### DISCLOSURE OF THE INVENTION

### TECHNICAL PROBLEM

Embodiments disclosed herein are intended to provide a battery diagnostic device for acquiring the temperature of each of battery cells included in a battery unit through electrochemical cell data and a method thereof.

Embodiments disclosed herein are intended to provide a battery diagnostic device for improving a performance of state diagnosis of battery cells by acquiring the temperature of each of the battery cells included in a battery unit and a method thereof.

Embodiments disclosed herein are intended to provide a battery diagnostic device for improving accuracy of capacity measurement of battery cells by acquiring the temperature of each of the battery cells included in a battery unit and a method thereof.

The technical problems of the present disclosure are not limited to those mentioned above, and other objectives not mentioned will be clearly understood by those skilled in the art from the following descriptions.

### TECHNICAL SOLUTION

A battery diagnostic device according to an embodiment of the present disclosure may include a memory storing at least one instruction and at least one processor executing the at least one instruction.

According to an embodiment, the at least one processor may acquire a set of reference data of a reference battery cell corresponding to each of a plurality of designated temperatures, acquire cell data of a battery cell at a specific temperature, fit each piece of reference data to the cell data such that deviations between each of the pieces of reference data included in the set of reference data and the cell data are minimized, identify first specific reference data included in the set of reference data and corresponding to a smallest deviation among deviations between each of the fitted pieces of reference data and the cell data, and diagnose a state of the battery cell based on a temperature corresponding to the first specific reference data corresponding to the smallest deviation among the plurality of designated temperatures.

According to an embodiment, the at least one processor may divide the cell data into a plurality of sections, identify section data included in at least a portion of the cell data and included in any one of the plurality of sections, fit each piece of reference data to the section data such that deviations between each of the pieces of reference data and the section data are minimized, identify second specific reference data included in the set of reference data and corresponding to a smallest deviation among the deviations between each of the fitted pieces of reference data and the section data, and identify a temperature of the battery cell in the section based on a temperature at which the second specific reference data is acquired among the plurality of designated temperatures.

According to an embodiment, the at least one processor may acquire the cell data of the battery cell in an activation process of the battery cell.

According to an embodiment, the at least one processor may identify, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures and identify, based on the first reference data and the second reference data, the set of reference data corresponding to each of the plurality of designated temperatures.

According to an embodiment, the at least one processor may identify a portion of the set of reference data corresponding to each of temperatures higher than the first temperature and lower than the second temperature among the plurality of designated temperatures by interpolating the first reference data and the second reference data and identify the set of reference data based on the portion of the set of reference data, the first reference data, and the second reference data.

According to an embodiment, each piece of reference data may include a capacity profile of the reference battery cell and a voltage profile of the reference battery cell, and the at least one processor may fit each piece of reference data to the cell data by performing, on the capacity profile or the voltage profile, at least one of a calculation of a specific first value, an addition of a specific second value, or any combination thereof.

According to an embodiment, the cell data may include a capacity profile of the battery cell included in a specified capacity range and a voltage profile of the battery cell according to the capacity profile.

According to an embodiment, each of the deviations between each of the pieces of reference data and the cell data may include a root mean squared error (RMSE) between each of the pieces of reference data and the cell data.

According to an embodiment, the at least one processor may identify the specific temperature based on a temperature corresponding to the first specific reference data, among the plurality of designated temperatures.

A battery diagnosis method according to another embodiment of the present disclosure may include acquiring a set of reference data of a reference battery cell corresponding to each of a plurality of designated temperatures, acquiring cell data of a battery cell at a specific temperature, fitting each piece of reference data to the cell data such that deviations between each of the pieces of reference data included in the set of reference data and the cell data are minimized, identifying first specific reference data included in the set of reference data and corresponding to a smallest deviation among deviations between each of the fitted pieces of reference data and the cell data, and diagnosing a state of the battery cell based on a temperature corresponding to the first specific reference data corresponding to the smallest deviation among the plurality of designated temperatures.

According to an embodiment, the battery diagnosis method may further include dividing the cell data into a plurality of sections, identifying section data included in at least a portion of the cell data and included in any one of the plurality of sections, fitting each piece of reference data to the section data such that deviations between each of the pieces of reference data and the section data are minimized, identifying second specific reference data included in the set of reference data and corresponding to a smallest deviation among the deviations between each of the fitted piece of reference data and the section data, and identifying a temperature of the battery cell in the section based on a temperature at which the second specific reference data is acquired among the plurality of designated temperatures.

According to an embodiment, the acquiring of the cell data of the battery cell at the specific temperature may be performed in an activation process of the battery cell.

According to an embodiment, the acquiring of the set of reference data of the reference battery cell corresponding to each of the plurality of designated temperatures may include identifying, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures and identifying, based on the first reference data and the second reference data, the set of reference data corresponding to each of the plurality of designated temperatures.

According to an embodiment, the identifying of, based on the first reference data and the second reference data, the set of reference data corresponding to each of the plurality of designated temperatures may include identifying a portion of the set of reference data corresponding to each of temperatures higher than the first temperature and lower than the second temperature among the plurality of designated temperatures by interpolating the first reference data and the second reference data and identifying the set of reference data based on the portion of the set of reference data, the first reference data, and the second reference data.

According to an embodiment, each of the pieces of reference data may include a capacity profile of the reference battery cell and a voltage profile of the reference battery cell, and the fitting of each of the pieces of reference data to the cell data such that the deviations between each of the pieces of reference data included in the set of reference data and the cell data are minimized may include fitting each piece of reference data to the cell data by performing, on the capacity profile or the voltage profile, at least one of a calculation of a specific first value, an addition of a specific second value, or any combination thereof.

According to an embodiment, the cell data may include a capacity profile of the battery cell included in a specified capacity range and a voltage profile of the battery cell according to the capacity profile.

According to an embodiment, each of the deviations between each of the pieces of reference data and the cell data may include an RMSE between each of the pieces of reference data and the cell data.

According to an embodiment, the diagnosing of the state of the battery cell based on the temperature corresponding to the first specific reference data corresponding to the smallest deviation among the plurality of designated temperatures may include identifying the specific temperature based on a temperature corresponding to the first specific reference data, among the plurality of designated temperatures.

A battery diagnostic device according to an embodiment of the present disclosure may include a memory storing at least one instruction and at least one processor executing the at least one instruction.

According to an embodiment, the at least one processor may obtain a set of reference data of a reference battery cell corresponding to each of a plurality of designated temperatures, obtain cell data from a battery cell at a specific temperature, fit each piece of reference data to the cell data such that deviations between each piece of reference data included in the set of reference data and the cell data are minimized, identify first specific reference data included in the set of reference data and corresponding to a smallest deviation among deviations between each of the fitted pieces of reference data and the cell data, and diagnose a state of the battery cell based on a value of a parameter related to the fitting of the first specific reference data.

According to an embodiment, each piece of reference data may include a capacity profile of the reference battery cell and a voltage profile of the reference battery cell, and the at least one processor may fit each piece of reference data to the cell data by performing, on the capacity profile or the voltage profile, at least one of a calculation of a specific first value, an addition of a specific second value, or any combination thereof.

According to an embodiment, the at least one processor may identify a value of the parameter based on the first value.

According to an embodiment, the at least one processor may identify, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures and identify, based on the first reference data and the second reference data, the set of reference data corresponding to each of the plurality of designated temperatures.

According to an embodiment, the at least one processor may identify a portion of a set of reference data corresponding to each of temperatures higher than the first temperature and lower than the second temperature among a plurality of designated temperatures by interpolating the first reference data and the second reference data, and identify the set of reference data based on the portion of the set of reference data, the first reference data, and the second reference data.

According to an embodiment, the first value related to the value of the parameter and a capacity of the battery cell may have a positive correlation.

According to an embodiment, the cell data may include a capacity profile of the battery cell included in a specified capacity range and a voltage profile of the battery cell according to the capacity profile.

According to an embodiment, the reference data may be acquired while the reference battery cell is being charged at a specified rate, or is acquired while the reference battery cell is being discharged, and the cell data may be acquired while the battery cell is being charged at the specified rate, or is acquired while the battery cell is being discharged.

According to an embodiment, the at least one processor may identify the capacity of the battery cell output from a learning model based on inputting the value of the parameter into the learning model trained to learn a correlation between the parameter and the capacity of the battery cell.

According to an embodiment, the at least one processor may identify the capacity of the battery cell output from a learning model based on inputting the value of the parameter into the learning model trained to learn a correlation between the parameter and the capacity of the battery cell.

According to an embodiment, the at least one processor may identify the capacity of the battery cell output from a learning model based on inputting the value of the parameter into the learning model trained to learn a correlation between the parameter and the capacity of the battery cell.

A battery diagnosis method according to an embodiment of the present disclosure may include acquiring a set of reference data of a reference battery cell corresponding to each of a plurality of designated temperatures, acquiring cell data of a battery cell at a specific temperature, fitting each piece of reference data to the cell data such that deviations between each of the pieces of reference data included in the set of reference data and the cell data are minimized, identifying first specific reference data included in the set of reference data and corresponding to a smallest deviation among deviations between each of the fitted pieces of reference data and the cell data, and diagnosing a state of the battery cell based on a value of a parameter related to fitting of the first specific reference data.

According to an embodiment, each of the pieces of reference data may include a capacity profile of the reference battery cell and a voltage profile of the reference battery cell, and the fitting of each of the pieces of reference data to the cell data such that the deviations between each of the pieces of reference data included in the set of reference data and the cell data are minimized may include fitting each piece of reference data to the cell data by performing, on the capacity profile or the voltage profile, at least one of a calculation of a specific first value, an addition of a specific second value, or any combination thereof.

According to an embodiment, the diagnosing of the state of the battery cell based on the value of the parameter related to the fitting of the first specific reference data may include identifying the value of the parameter based on the first value.

According to an embodiment, the acquiring of the set of reference data of the reference battery cell corresponding to each of the plurality of designated temperatures may include identifying, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures and identifying, based on the first reference data and the second reference data, the set of reference data corresponding to each of the plurality of designated temperatures.

According to an embodiment, the identifying of, based on the first reference data and the second reference data, the set of reference data corresponding to each of the plurality of designated temperatures may include identifying a portion of the set of reference data corresponding to each of temperatures higher than the first temperature and lower than the second temperature among the plurality of designated temperatures by interpolating the first reference data and the second reference data and identifying the set of reference data based on the portion of the set of reference data, the first reference data, and the second reference data.

According to an embodiment, the first value related to the value of the parameter and a capacity of the battery cell may have a positive correlation.

According to an embodiment, the cell data may include a capacity profile of the battery cell included in a specified capacity range and a voltage profile of the battery cell according to the capacity profile.

According to an embodiment, the reference data may be acquired while the reference battery cell is being charged at a specified rate, or is acquired while the reference battery cell is being discharged, and the cell data may be acquired while the battery cell is being charged at the specified rate, or is acquired while the battery cell is being discharged.

According to an embodiment, the diagnosing of the state of the battery cell based on the value of the parameter related to the fitting of the first specific reference data may include acquiring a capacity of the battery cell based on a value of a parameter related to fitting of the first specific reference data.

According to an embodiment, the acquiring of the capacity of the battery cell based on the value of the parameter related to fitting of the first specific reference data may include identifying the capacity of the battery cell output from a learning model based on inputting the value of the parameter into the learning model trained to learn a correlation between the parameter and the capacity of the battery cell.

### ADVANTAGEOUS EFFECTS

The present technology can acquire the temperature of each of battery cells included in a battery unit through electrochemical cell data.

In addition, the present technology can improve the performance of state diagnosis of battery cells by acquiring the temperature of each of the battery cells included in a battery unit.

In addition, the present technology can improve accuracy of capacity measurement of battery cells by acquiring the temperature of each of the battery cells included in a battery unit.

Besides, various effects may be provided that are directly or indirectly identified through the present disclosure.

### BRIEF DESCRIPTION OF THE DRAWINGS

FIG. 1 is a block diagram illustrating a battery pack, in a battery diagnostic device and a battery diagnosis method according to an embodiment of the present disclosure.
FIG. 2 is a block diagram illustrating the configuration of a battery diagnostic device, in a battery diagnostic device and a battery diagnosis method according to an embodiment of the present disclosure.
FIG. 3 illustrates an example of a graph representing reference data fitted to cell data and the cell data, in the battery diagnostic device and the battery diagnosis method according to an embodiment of the present disclosure.
FIG. 4 illustrates an example of a graph representing a deviation between reference data and cell data, in a battery diagnostic device and a battery diagnosis method according to an embodiment of the present disclosure.
FIG. 5 illustrates an example of a graph representing a line obtained by differentiating voltage included in reference data with respect to capacity and a line obtained by differentiating voltage included in cell data with respect to capacity, in a battery diagnostic device and a battery diagnosis method according to an embodiment of the present disclosure.
FIG. 6 illustrates an example of a graph representing a line obtained by differentiating capacity included in reference data with respect to voltage and a line obtained by differentiating capacity included in cell data with respect to voltage, in the battery diagnostic device and the battery diagnosis method according to an embodiment of the present disclosure.
FIG. 7 illustrates an example of a graph representing a set of reference data, in a battery diagnostic device and a battery diagnosis method according to an embodiment of the present disclosure.
FIG. 8 illustrates a diagram and a table representing a temperature distribution of battery cells, in a battery diagnostic device and a battery diagnosis method according to an embodiment of the present disclosure.
FIG. 9 illustrates an example of a learning model for identifying a capacity of a battery cell, in a battery diagnostic device and a battery diagnosis method according to an embodiment of the present disclosure.
FIG. 10 illustrates an example of a diagram representing degrees of influence of a plurality of factors of a learning model for identifying the capacity of a battery cell, in a battery diagnostic device and a battery diagnosis method according to an embodiment of the present disclosure.
FIG. 11 illustrates a graph representing predicted temperatures and parameters of a battery cell, in a battery diagnostic device and a battery diagnosis method according to an embodiment of the present disclosure.
FIG. 12 illustrates a graph representing the accuracy of capacity prediction for a battery cell of a learning model, in a battery diagnostic device and a battery diagnosis method according to an embodiment of the present disclosure.
FIG. 13 illustrates an example of a flow of operations of a battery diagnostic device for identifying a temperature of a battery cell, in the battery diagnostic device and a battery diagnosis method according to an embodiment of the present disclosure.
FIG. 14 illustrates an example of a flow of operations of a battery diagnostic device for identifying a capacity of a battery cell, in the battery diagnostic device and a battery diagnosis method according to an embodiment of the present disclosure.
FIG. 15 is a block diagram illustrating a hardware configuration of a computing system for performing a battery diagnosis method, in a battery diagnostic device and a battery diagnosis method according to an embodiment of the present disclosure.

### MODE FOR CARRYING OUT THE INVENTION

Hereinafter, some embodiments disclosed herein are described with reference to the accompanying drawings of various embodiments of the present disclosure. However, this is not intended to limit the present technology to the specific embodiments, and it is to be construed to include various modifications, equivalents, and/or alternatives of embodiments of the present technology.

In adding reference numerals to the components of each drawing, it should be noted that the same components are given the same reference numerals as much as possible even though they are shown on different drawings. In addition, in describing various embodiments disclosed herein, when a detailed description of a related known configuration or function is determined to hinder understanding of the embodiments of the present invention, the detailed description thereof is omitted. It is to be understood that a singular form of a noun corresponding to an item may include one or more of the things, unless the relevant context clearly indicates otherwise.

In addition, in describing a component of the embodiments of the present disclosure, terms such as first, second, A, B, (a), (b), etc. may be used. These terms are only for distinguishing the component from other components, and the essence, sequence, or order of the component may not be limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

In addition, in the present disclosure, in order to determine whether a specific condition is satisfied or fulfilled, expressions "more than" or "less than" may be used, but this is only a description for expressing an example and does not exclude descriptions of "equal to or more than" or "less than or equal to." A condition described as "equal to or more than" may be replaced with "more than," a condition described as "less than or equal to" may be replaced with "less than," and a condition described as "equal to or more than and less than" may be replaced with "more than and less than or equal to." In addition, hereinafter, "A to B" mean at least one of the elements from A (inclusive of A) to B (inclusive of B).

In the present disclosure, each of phrases such as "A or B," "at least one of A and B," "at least one of A or B," "A, B or C," "at least one of A, B and C," or "at least one of A, B, or C," may include any one of the items listed in the phrase, or all possible combinations of the phrases.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the described components may include a single entity or multiple entities, and some of the plurality of entities may be disposed separately from other components. According to various embodiments, at least one of components or operations of the above-described components may be omitted, or at least one of other components or operations may be added. Alternatively or additionally, a plurality of components (e.g., modules or programs) may be integrated into a single component. In such a case, the integrated component may still perform at least one of functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or at least one of other operations may be added.

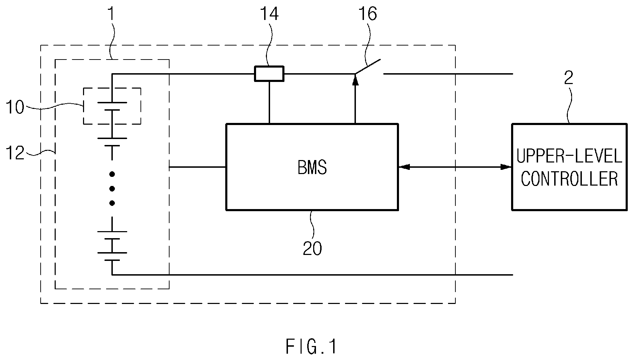

Hereinafter, embodiments of the present disclosure will be described in detail with reference to FIGS. 1 to 15.

FIG. 1 is a block diagram illustrating a battery pack in a battery diagnostic device and a battery diagnosis method according to an embodiment of the present disclosure.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). For this purpose, the battery unit 12 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to an embodiment, the battery unit 12 may include at least one battery cell 10 that is rechargeable and dischargeable. Here, the battery cell 10 may be a basic unit of a battery cell that may be used by being charged and discharged with electric energy. For example, the battery cell 10 may be a lithium ion (Li-ion) battery, a lithium ion (Li-ion) polymer battery, a nickel cadmium (Ni-Cd) battery, a nickel hydrogen (Ni-MH) battery, or the like, and may not be limited thereto.

According to an embodiment, a plurality of battery units 12 may be connected in series or in parallel. For example, the battery unit 12 may be a battery module, a battery bank, or a collection of battery cells (cell-to-pack structure).

According to an embodiment, the sensor unit 14 may acquire information related to the battery unit 12. According to an embodiment, the sensor unit 14 may acquire values (or information) related to the state of each of the battery units 12 or battery cells 10. In an embodiment, the state-related values may include at least one values of a voltage, current, resistance, state of charge (SOC), state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling the current flow for charging or discharging the battery unit 12. For example, the switching unit 16 may include at least one relay and/or magnetic contactor, depending on the specifications of the battery pack 1.

According to an embodiment, the battery management system (BMS) 20 may control or manage the battery pack 1 to prevent overcharge and over-discharge by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of the relay, the contactor, or the like.

According to an embodiment, the operation of the battery management system 20 may be performed by the BMS (battery management system) in a vehicle, as well as by various devices such as a server, a cloud, a charger, a discharger, or the like.

An upper-level controller 2 may transmit a control signal for the plurality of battery units 12 to the battery management system 20. Accordingly, the operation of the battery management system 20 may be controlled based on the signal received from the upper controller 2.

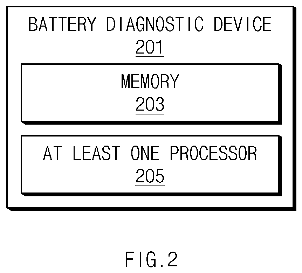

According to an embodiment, the battery management system 20 may include a battery diagnostic device 201 in FIG. 2. In another embodiment, the battery management system 20 may be a system different than the battery diagnostic device 201 in FIG. 2. That is, the battery diagnostic device 201 in FIG. 2 may be included in the battery pack 1 or may be configured as another device external to the battery pack 1. For convenience of description, the following description assumes that the battery diagnostic device 201 is configured as another device external to the battery pack 1. In addition, the operation of the battery diagnostic device 201 below may be performed by a battery management system (BMS) in the vehicle, as well as by various devices such as a server, a cloud, a charger, a discharger, or the like.

FIG. 2 is a block diagram illustrating the configuration of a battery diagnostic device, in a battery diagnostic device and a battery diagnosis method according to an embodiment of the present disclosure.

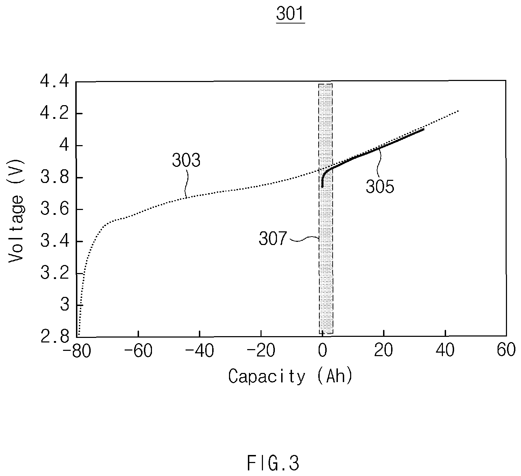

FIG. 3 illustrates an example of a graph representing reference data fitted to cell data and the cell data, in the battery diagnostic device and the battery diagnosis method according to an embodiment of the present disclosure.

Referring to FIGS. 2 and 3, a battery diagnostic device 201 may include a memory 203 and at least one processor 205. The memory 203 may store at least one instruction. The at least one processor 205 may execute the at least one instruction.

A graph 301 may represent reference data fitted to cell data and the cell data. A first line 303 may represent reference data included in a set of reference data. In other words, the first line 303 may represent a voltage versus capacity graph of a reference battery cell at one of a plurality of designated temperatures. A second line 305 may represent the cell data. In other words, the second line 305 may represent a voltage versus capacity graph of a battery cell at a specific temperature. A region 307 may represent a portion that is outside a specified capacity range in the cell data. The cell data referred to below may include data from a target battery cell. The reference data may include data from a reference battery cell that serves as a reference.

In order to increase accuracy of capacity measurement of a battery unit (e.g., a battery pack, a battery module), detect abnormalities of the battery unit, improve the quality of the battery unit, or monitor the battery unit, at least one processor 205 may measure the temperature of the battery unit.

This is because the performance of the battery unit is determined by the capacity of the battery unit and the voltage of the battery unit and the capacity measurement of the battery unit may be affected by temperature. In addition, when the temperature of the battery unit does not meet a specified range, an abnormality in the battery unit may be detected.

In particular, during an activation process, the temperature of the battery unit may be used as an indicator for identifying the uniformity and stability of chemical reactions occurring inside the battery unit, and may also be used as an indicator for detecting abnormalities.

Here, the capacity, abnormality, and quality of the battery unit may be determined based on the capacity, abnormality, and quality of individual battery cells. The capacity, abnormality, and quality of individual battery cells included in the battery unit may vary from battery cell to battery cell. Therefore, in order to improve the accuracy of capacity measurement of the battery unit and the accuracy of abnormality determination, at least one processor 205 may need to measure the temperature of individual battery cells.

In addition, the temperature of individual battery cells in the activation process may be used as an indicator for identifying the uniformity of quality among battery cells, and may also be used to identify the cause of an abnormality in an abnormal battery cell.

A temperature sensor may not be attached to each battery cell, but may be attached to each battery unit. This is because the cost required for temperature measurement when a temperature sensor is attached to each battery cell is greater than the cost required for temperature measurement when a temperature sensor is attached to each battery unit. Therefore, the battery diagnostic device had difficulty in measuring the temperature of individual battery cells through a temperature sensor.

According to an embodiment, the battery diagnostic device 201 may identify the temperature of an individual battery cell or the capacity of an individual battery cell based on an electrochemical signal from the battery cell.

According to an embodiment, at least one processor 205 may acquire cell data of a battery cell at a specific temperature. The cell data may include a capacity profile of the battery cell included in a specified capacity range, and a voltage profile of the battery cell according to the capacity profile. According to an embodiment, the cell data of the battery cell may be acquired in the activation process of the battery cell, but embodiments of the present disclosure may not be limited thereto.

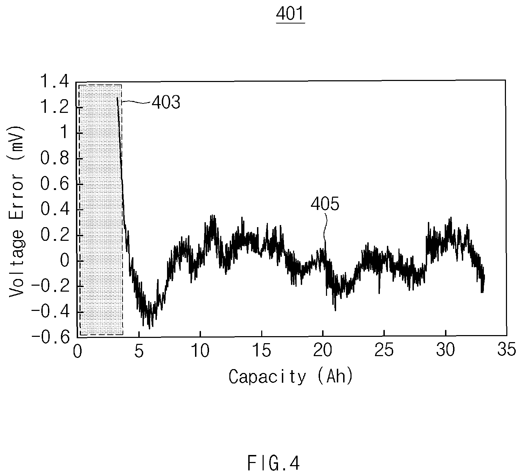

For example, the cell data may include a voltage versus capacity graph (e.g., the second line 305) of a battery cell having a capacity that is included in a specified capacity range at a specific temperature. The specified capacity range may not include a capacity in the region 307. Referring to the specified capacity range may be intended to increase the accuracy of fitting. The specified capacity range will be described below with reference to FIG. 4.

According to an embodiment, at least one processor 205 may acquire a set of reference data (e.g., a capacity profile of the reference battery cell and a voltage profile of the reference battery cell) corresponding to each of a plurality of designated temperatures of the reference battery cell having a value of a current profile that is the same as a value of a current profile (e.g., current, current density) of the battery cell from which cell data is acquired.

In other words, the reference data may be acquired while the reference battery cell is being charged or while the reference battery cell is being discharged, at a specified rate that is the same as the rate at which the battery cell is being charged or discharged.

According to an embodiment, the set of reference data may include a set of capacity profiles of the reference battery cell corresponding to each of the plurality of designated temperatures, or a set of voltage profiles of the reference battery cell corresponding to each of a plurality of designated temperatures.

For example, the set of reference data may include a voltage versus capacity graph of the reference battery cell at about 25°C, a voltage versus capacity graph of the reference battery cell at about 26°C, a voltage versus capacity graph of the reference battery cell at about 27°C, a voltage versus capacity graph of the reference battery cell at about 28°C, or a voltage versus capacity graph of the reference battery cell at about 29°C. The first line 303 may represent a voltage versus capacity graph of the reference battery cell at about 33°C.

According to an embodiment, at least one processor 205 may fit each piece of reference data to the cell data such that deviations between each piece of reference data included in the set of reference data and the cell data are minimized.

For example, at least one processor 205 may shrink or expand a voltage versus capacity graph of the reference battery cell with respect to the capacity profile by calculating a first value specific to the capacity profile of the voltage versus capacity graph according to the capacity of the reference battery cell at about 25°C included in the reference data.

For example, at least one processor 205 may move the voltage versus capacity graph of the reference battery cell at about 25°C along a capacity profile axis or a voltage profile axis by adding a specific second value to the capacity profile or the voltage profile of the voltage versus capacity graph of the reference battery cell.

For example, at least one processor 205 may fit the reference data to the cell data by shrinking, expanding, or moving the reference data such that the deviations between the reference data and the cell data are minimized.

For example, at least one processor 205 may fit each piece of reference data included in the set of reference data (e.g., the voltage versus capacity graph of the reference battery cell at about 25°C, the voltage versus capacity graph of the reference battery cell at about 33°C, or a voltage versus capacity graph of a reference battery cell at about 35°C) to the cell data.

According to an embodiment, at least one processor 205 may identify first specific reference data (e.g., the first line 303) corresponding to the smallest deviation among the deviations of each of the fitted pieces of reference data and the cell data.

For example, the minimized deviation of the voltage versus capacity graph of the reference battery cell at about 25°C and the cell data may be about 0.29117 mV (millivoltage), the minimized deviation at about 33°C may be about 0.15843 mV, and the minimized deviation at about 35°C may be about 0.21843 mV.

According to an embodiment, at least one processor 205 may identify a specific temperature of the battery cell based on a temperature corresponding to the first specific reference data (e.g., about 33°C) among a plurality of designated temperatures.

For example, at least one processor 205 may identify the temperature of the battery cell as about 33°C since the temperature corresponding to the first specific reference data is about 33°C.

In FIGS. 2 and 3, each piece of reference data is described to be fitted with the entire cell data, but the embodiments of the present disclosure may not be limited thereto.

According to an embodiment, at least one processor 205 may divide the cell data into a plurality of sections, identify section data included in at least a portion of the cell data and included in any one of the plurality of sections, and fit each piece of reference data to the section data such that a deviation between each piece reference data and the section data is minimized. This is because the temperature of the battery cell may change while the battery cell is being charged or discharged and cell data is being acquired.

According to an embodiment, at least one processor 205 may identify second specific reference data included in the set of reference data and corresponding to the smallest deviation among the deviations of each of the fitted pieces of reference data and the section data. At least one processor 205 may identify the temperature of the battery cell in any one section based on a temperature at which the second specific reference data is acquired, among a plurality of designated temperatures.

FIG. 4 illustrates an example of a graph representing a deviation between reference data and cell data, in a battery diagnostic device and a battery diagnosis method according to an embodiment of the present disclosure.

Referring to FIG. 4, a graph 401 may represent a deviation between the reference data and the cell data. A line 405 may represent a deviation between any one piece of reference data and the cell data. A region 403 may represent a region in which the deviation is greater than or equal to a reference value (e.g., about 0.6 mV). The deviation between the reference data and the cell data may include an root mean squared error (RMSE) between the reference data and the cell data.

According to an embodiment, the cell data may include a capacity profile of a battery cell included in a range from a specified first capacity or greater to less than a specified second capacity, and a voltage profile of the battery cell according to the capacity profile. The specified second capacity may be greater than the specified first capacity.

According to an embodiment, when the cell data is acquired, a deviation reaching or exceeding a reference value may occur due to a difference between a starting potential of a reference battery cell and a starting potential of the battery cell. As the deviation becomes closer to zero, a degree to which the reference data is fitted to the cell data may increase. Referring to the graph 401, even though a degree to which a portion of the cell data corresponding to a region other than the region 403 is fitted is greater than or equal to a reference fitting degree, a degree to which a portion of the cell data corresponding to the region 403 is fitted may be less than the reference fitting degree.

Therefore, at least one processor 205 may fit the reference data based on the cell data of the battery cell not included in the region 307 to increase the accuracy of the fitting. In other words, at least one processor 205 may fit the reference data based on the capacity profile of the battery cell having the specified first capacity or greater, and the voltage profile of the battery cell according to the capacity profile.

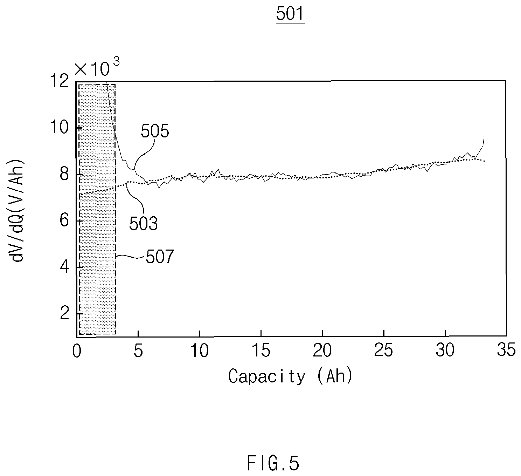

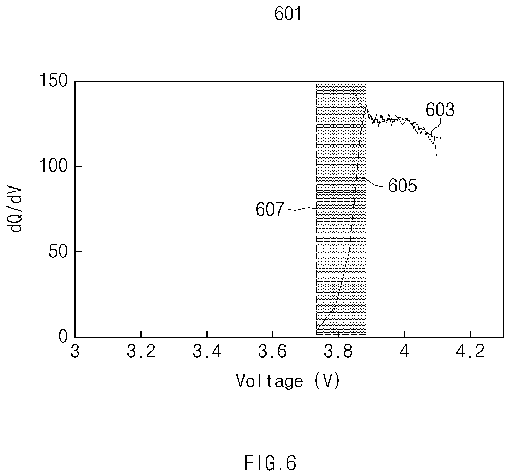

The region 307 of FIG. 3, a region 507 of FIG. 5, and a region 607 of FIG. 6 may also represent regions to be excluded from the cell data to increase the accuracy of the fitting.

In FIG. 4, only the region 307 representing the specified first capacity, which is a reference for reducing the occurrence of the deviations reaching or exceeding the reference value due to the starting potential of the battery cell, is illustrated, but even when the battery cell is charged to the specified second capacity or more, deviations reaching or exceeding the reference value may occur due to overvoltage.

Therefore, at least one processor 205 may fit the reference data based on the capacity profile of the battery cell less than the second capacity and the voltage profile of the battery cell according to the capacity profile to increase the accuracy of the fitting.

FIG. 5 illustrates an example of a graph representing a line obtained by differentiating voltage included in reference data with respect to capacity and a line obtained by differentiating voltage included in cell data with respect to capacity, in a battery diagnostic device and a battery diagnosis method according to an embodiment of the present disclosure.

FIG. 6 illustrates an example of a graph representing a line obtained by differentiating capacity included in reference data with respect to voltage and a line obtained by differentiating capacity included in cell data with respect to voltage, in the battery diagnostic device and the battery diagnosis method according to an embodiment of the present disclosure.

Referring to FIGS. 5 and 6, a first graph 501 is a graph of voltage differentiated with respect to capacity for reference data and cell data, and may include a first line 503 and a second line 505. The first line 503 may represent a graph of the voltage of the reference battery cell differentiated with respect to the capacity of the reference battery cell, based on the reference data. The second line 505 may represent a graph of the voltage of a battery cell differentiated with respect to the capacity of the battery cell, based on the cell data. A first region 507 may represent a region in which an absolute value of a difference between the first line 503 and the second line 505 is greater than or equal to a reference value.

A second graph 601 is a graph of capacity differentiated with respect to voltage for the reference data and the cell data, and may include a third line 603 and a fourth line 605. A third line 603 may represent a graph of the capacity of the reference battery cell differentiated with respect to the voltage of the reference battery cell, based on the reference data. The fourth line 605 may represent a graph of the capacity of the reference battery cell differentiated with the voltage of the reference battery cell, based on the reference data. A second region 507 may represent a region in which an absolute value of a difference between the first line 503 and the second line 505 is greater than or equal to a reference value.

According to an embodiment, the smaller a difference between the first line 503 and the second line 505 is, the higher the fitting degree may be. This is because, as the difference between the first line 503 and the second line 505 decreases, a difference between a slope of the cell data and a slope of the reference data also decreases. Referring to the graph 501, even though a degree to which a portion of the cell data corresponding to a region other than the region 507 is fitted is greater than or equal to a reference fitting degree, a degree to which a portion of the cell data corresponding to the region 507 is fitted may be less than the reference fitting degree.

Therefore, at least one processor 205 may fit the reference data based on the cell data of the battery cell not included in the region 507 to increase the fitting degree. In other words, at least one processor 205 may fit the reference data based on the capacity profile of the battery cell included in a specified capacity range, and the voltage profile of the battery cell according to the capacity profile.

According to an embodiment, the smaller the difference between the third line 603 and the fourth line 605, the smaller the difference between the slope of the cell data and the slope of the reference data, and thus the fitting degree may be higher. Referring to the graph 601, similar to the graph 501, even though a degree to which a portion of the cell data corresponding to a region other than the region 607 is fitted is greater than or equal to a reference fitting degree, a degree to which a portion of the cell data corresponding to the region 607 is fitted may be less than the reference fitting degree.

Therefore, at least one processor 205 may fit the reference data based on the cell data of the battery cell not included in the region 607 to increase the fitting degree. In other words, at least one processor 205 may fit the reference data based on the capacity profile of the battery cell included in the specified capacity range, and the voltage profile of the battery cell according to the capacity profile.

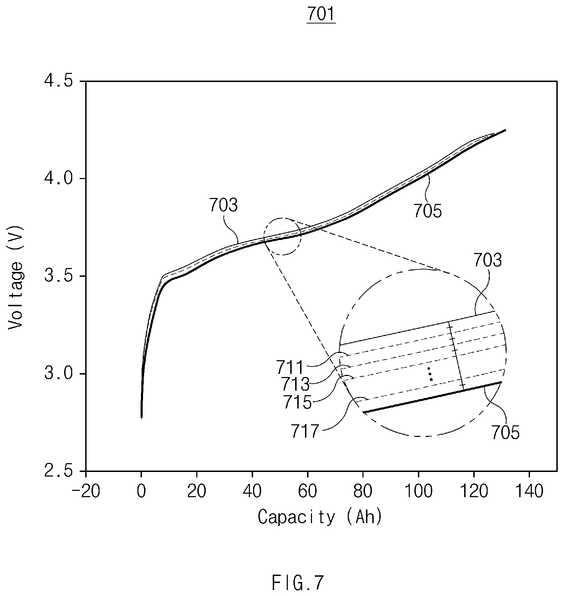

FIG. 7 illustrates an example of a graph representing a set of reference data, in a battery diagnostic device and a battery diagnosis method according to an embodiment of the present disclosure.

Referring to FIG. 7, a graph 701 may represent reference data as a voltage versus capacity graph. A first line 703 may represent first reference data of a reference battery cell acquired at a first temperature (e.g., about 25°C) that is the lowest among a plurality of designated temperatures. A second line 705 may represent second reference data of the reference battery cell acquired at a second temperature (e.g., about 45°C) that is the highest among the plurality of designated temperatures.

A third line 711 may represent reference data at a third temperature (e.g., about 26°C) between the first temperature and the second temperature. A fourth line 713 may represent reference data at a fourth temperature (e.g., about 27°C) between the third temperature and the second temperature. A fifth line 715 may represent reference data at a fifth temperature (e.g., about 28°C) between the fourth temperature and the second temperature. A sixth line 717 may represent reference data at a sixth temperature (e.g., about 44°C) between the fifth temperature and the second temperature. The third temperature may be higher than the first temperature, the fourth temperature may be higher than the third temperature, the fifth temperature may be higher than the fourth temperature, the sixth temperature may be higher than the fifth temperature, and the second temperature may be higher than the sixth temperature.

According to an embodiment, at least one processor 205 may identify a portion (e.g., the third line 711, the fourth line 713, the fifth line 715, and the sixth line 717) of a set of reference data corresponding to each of the temperatures higher than the first temperature and lower than the second temperature among a plurality of designated temperatures by interpolating the first line 703 representing the first reference data and the second line 705 representing the second reference data.

For example, at least one processor 205 may acquire voltage values of reference data at the plurality of designated temperatures corresponding to a specific capacity by dividing a range between a first voltage value of the first reference data corresponding to a specific capacity and a second voltage value of the second reference data corresponding to the specific capacity into a designated number of sections (e.g., about 20 sections). The size of each section may be the same.

According to an embodiment, at least one processor 205 may identify the set of reference data based on a portion of the set of reference data, the first reference data, and the second reference data.

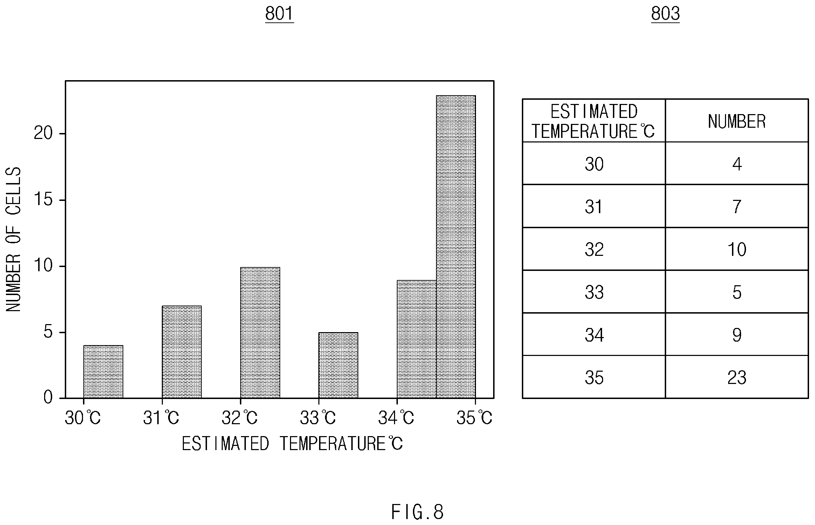

FIG. 8 illustrates a diagram and a table representing a temperature distribution of battery cells, in a battery diagnostic device and a battery diagnosis method according to an embodiment of the present disclosure.

Referring to FIG. 8, a diagram 801 may represent a temperature distribution of battery cells included in a battery unit. A table 803 may represent the temperature distribution of battery cells.

The battery diagnostic device according to an embodiment may identify the temperature distribution of each of the battery cells even in a process step in which identification of the temperature of each of the battery cells is difficult.

According to an embodiment, referring to the diagram 801 and the table 803, in the battery unit, the number of battery cells having a temperature of about 30°C may be about 4, the number of battery cells having a temperature of about 31°C may be about 7, the number of battery cells having a temperature of about 32°C may be about 10, the number of battery cells having a temperature of about 33°C may be about 5, the number of battery cells having a temperature of about 34°C may be about 9, and the number of battery cells having a temperature of about 35°C may be about 23.

According to an embodiment, an average temperature of the battery cells included in the battery unit may be about 33.3°C. While charging the battery unit, the average temperature of a charge/discharge device may be about 32.7°C, and the temperature of the charge/discharge device when charging is completed may be about 33.3°C.

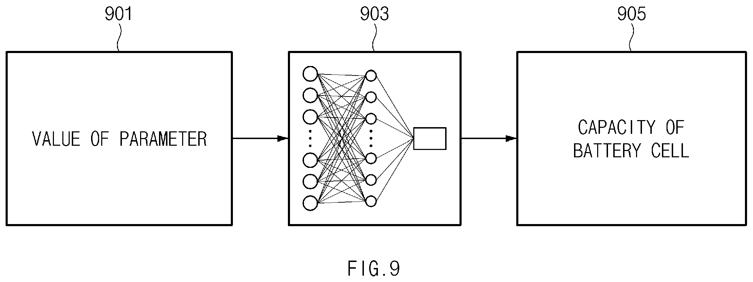

FIG. 9 illustrates an example of a learning model for identifying a capacity of a battery cell, in a battery diagnostic device and a battery diagnosis method according to an embodiment of the present disclosure.

Referring to FIG. 9, a learning model 903 may include a learning model trained to learn a correlation between a parameter related to fitting of first specific reference data and the capacity of the battery cell. The first specific reference data may correspond to the smallest deviation among the deviations between each fitted piece of reference data and the cell data.

According to an embodiment, at least one processor 205 of the battery diagnostic device 201 may input a value of a parameter of first specific reference data corresponding to the battery cell as input data 901, and output the capacity of the battery cell as output data 905 from the learning model 903.

According to an embodiment, when at least one processor 205 of the battery diagnostic device 201 include an artificial intelligence processor (e.g., a neural processing unit (NPU)) for training the artificial neural network (ANN) model, the artificial intelligence processor may train an artificial neural network by utilizing weight data stored in the memory as training data for the machine learning model.

According to an embodiment, examples of the learning algorithm may include supervised learning, unsupervised learning, self-supervised learn, semi-supervised learning, or reinforcement learning.

According to an embodiment, the artificial neural network included in the learning model may be composed of a plurality of neural network layers. Each of the plurality of neural network layers may have a plurality of weight values and perform neural network operations through operations between an operation result of a previous layer and the plurality of weight values. The plurality of weight values of the plurality of neural network layers may be optimized by a learning result of the artificial intelligence model. For example, the plurality of weight values may be updated so that a loss value or cost value acquired in the artificial intelligence model is reduced or minimized during a learning process.

According to an embodiment, the artificial neural network may include a deep neural network (DNN), and may be, for example, a convolutional neural network (CNN), a deep neural network (DNN), a recurrent neural network (RNN), a restricted boltzmann machine (RBM), a deep belief network (DBN), a bidirectional recurrent deep neural network (BRDNN), a deep Q-network, or the like, but may not be limited to the above examples.

According to an embodiment, at least one processor 205 of the battery diagnostic device 201 may output the capacity of the battery cell, which is output data 905 that is correlated with the value of the parameter of the first specific reference data, which is input data 901, based on the selected artificial intelligence model.

According to an embodiment, as the temperature of the battery cell increases, the slope of the voltage increase with respect to the capacity increase may become more gradual.

Therefore, as the temperature of the battery cell increases, a first value applied to a capacity profile of a reference battery cell to fit a reference battery profile to the battery cell may increase. As the first value increases, the value of the parameter may increase. As the temperature of the battery cell increases, the resistance of the battery cell may decrease. As the resistance of the battery cell decreases, the capacity of the battery cell may be measured to be higher.

Therefore, the first value of the first specific reference data and the capacity of the battery cell may have a positive correlation. However, the first value and the capacity of the battery cell may not be limited to having a linear positive correlation.

In addition, the value of the parameter of the first specific reference data and the capacity of the battery cell may have a positive correlation. Similarly to the first value, the value of the parameter and the capacity of the battery cell may not be limited to having a linear positive correlation.

The charge capacity of the battery cell identified through the learning model 903 may include the total capacity of the battery.

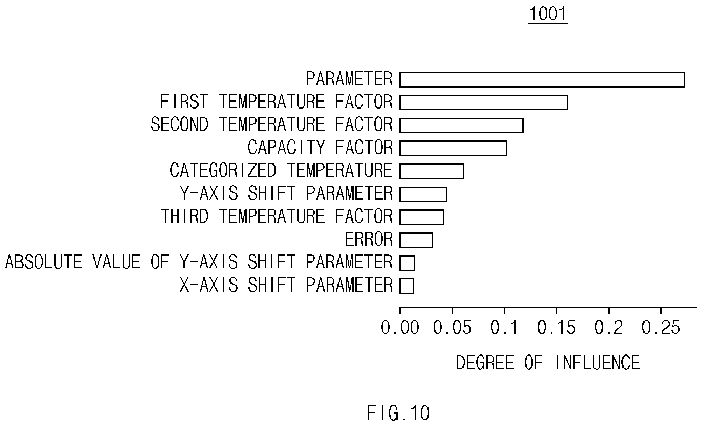

FIG. 10 illustrates an example of a diagram representing degrees of influence of a plurality of factors of a learning model for identifying the capacity of a battery cell, in a battery diagnostic device and a battery diagnosis method according to an embodiment of the present disclosure.

Referring to FIG. 10, a diagram 1001 may represent the degrees of influence of a plurality of factors input into a learning model (e.g., the learning model 903 of FIG. 9) for identifying the capacity of a battery cell as input data. The degree of influence of each of the plurality of factors may indicate the degree to which each factor is considered when the learning model derives output data from the input data.

According to an embodiment, the degree of influence of the parameter (e.g., the input data 901 of FIG. 9) may be the highest. A first temperature factor may represent an average temperature of a tray containing a plurality of battery cells when charging for shipment in an activation process. A second temperature factor may represent an average temperature of the tray during discharging within the activation process. A capacity factor may represent a capacity upon completion of a first charging within the activation process. A categorized temperature may represent a temperature of the battery cell corresponding to one of categorized temperatures at a designated interval (e.g., in units of about 1°C). A Y-axis shift parameter may represent the degree of shift along a Y-axis when the first specific reference data is fitted to the cell data. A third temperature factor may represent an average temperature during the first charging within the activation process. An error may represent the degree of symmetry in the overall profile. An absolute value of the Y-axis shift parameter of the battery cell may represent an absolute value of the degree of shift along the Y-axis when the first specific reference data is fitted to the cell data. An X-axis shift parameter may represent the degree of shift along an X-axis when the first specific reference data is fitted to the cell data.

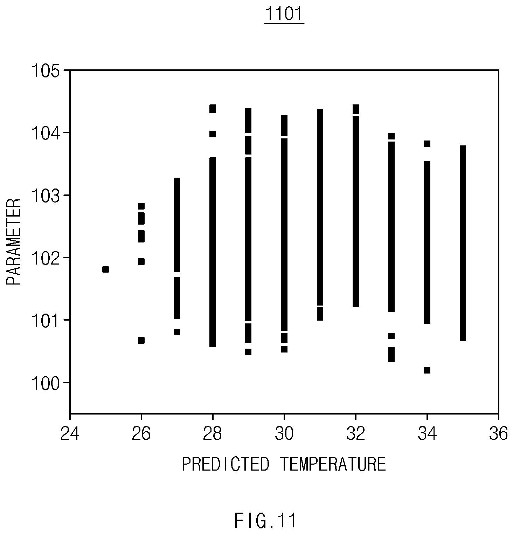

FIG. 11 illustrates a graph representing predicted temperatures and parameters of a battery cell, in a battery diagnostic device and a battery diagnosis method according to an embodiment of the present disclosure.

Referring to FIG. 11, the predicted temperature may represent a temperature predicted to be a temperature of a battery cell among the categorized temperatures. The parameter may represent a value determined based on a first value for performing a calculation on a capacity profile of reference data to fit the reference data to the cell data.

According to an embodiment, at least one processor 205 may predict the temperature of the battery cell through the plurality of factors described in FIG. 10 among the categorized temperatures. The predicted temperature may represent a temperature of the battery cell corresponding to one of categorized temperatures at a designated interval (e.g., in units of about 1°C).

According to an embodiment, at least one processor 205 may improve the accuracy of the temperature of the battery cell predicted through the parameters.

For example, referring to a graph 1101, the parameter of the reference data corresponding to a battery cell having a temperature of about 30°C may be distributed from about 100.5 to about 104. At least one processor 205 may refine the categorized predicted temperatures by referring to the parameters through the learning model of FIG. 9.

For example, referring to the graph 1101, when the parameter of the reference data corresponding to a first battery cell having the temperature of about 30°C is about 100.5 and the parameter of the reference data corresponding to a second battery cell having the temperature of about 30°C is about 104, the temperature of the first battery cell may be lower than the temperature of the second battery cell. By considering the parameter of the reference data corresponding to each battery cell, at least one processor 205 may identify the temperature of the battery cell. For example, the temperature of the first battery cell may be about 30°C, and the temperature of the second battery cell may be about 30.8°C.

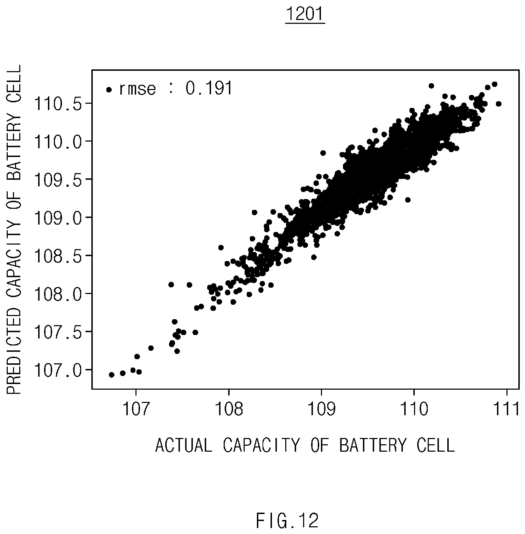

FIG. 12 illustrates a graph representing the accuracy of capacity prediction for a battery cell of a learning model, in a battery diagnostic device and a battery diagnosis method according to an embodiment of the present disclosure.

Referring to FIG. 12, a graph 1201 may represent a predicted capacity of a battery cell with respect to an actual capacity of the battery cell. The predicted capacity of the battery cell may be predicted through the learning model of FIG. 9.

According to an embodiment, as a root mean square error (RMSE) of the graph 1201 decreases, the prediction accuracy of a learning model (e.g., the learning model 903 of FIG. 9) may be improved. The RMSE of the graph 1201 may be about 0.191.

According to an embodiment, the learning model 903 may predict the capacity of the battery cell based on a plurality of factors (e.g., the plurality of factors of FIG. 10).

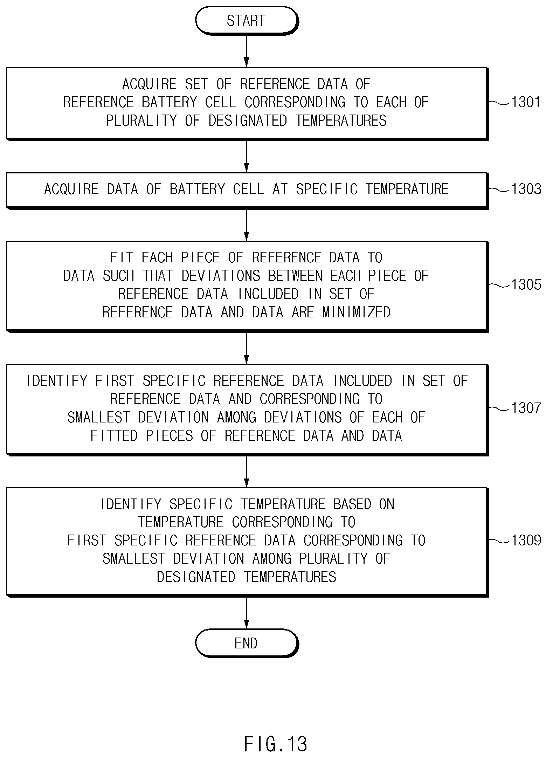

FIG. 13 illustrates an example of a flow of operations of a battery diagnostic device for identifying a temperature of a battery cell, in the battery diagnostic device and a battery diagnosis method according to an embodiment of the present disclosure.

Hereinafter, it is assumed that at least one processor 205 included in the battery diagnostic device 201 in FIG. 2 performs the process of FIG. 13. In addition, in the description of FIG. 13, it may be understood that the operations described as being performed by the battery diagnostic device 201 are controlled by at least one processor included in the battery diagnostic device 201.

Hereinafter, data of the battery cell may be understood as cell data of a target battery cell. Reference data may be understood as data of a reference battery cell that serves as a reference.

Referring to FIG. 13, in a first operation 1301, at least one processor 205 according to an embodiment may acquire a set of reference data of a reference battery cell corresponding to each of a plurality of designated temperatures.

In a second operation 1303, at least one processor 205 according to an embodiment may acquire cell data of a battery cell at a specific temperature.

In a third operation 1305, at least one processor 205 according to an embodiment may fit each piece of reference data to the cell data such that deviations between each piece of reference data included in the set of reference data and the cell data are minimized.

In a fourth operation 1307, at least one processor 205 according to an embodiment may identify first specific reference data included in the set of reference data and corresponding to the smallest deviation among the deviations of each of the fitted pieces of reference data and the cell data.

In a fifth operation 1309, at least one processor 205 according to an embodiment may identify a specific temperature based on a temperature corresponding to the first specific reference data corresponding to the smallest deviation among the plurality of designated temperatures.

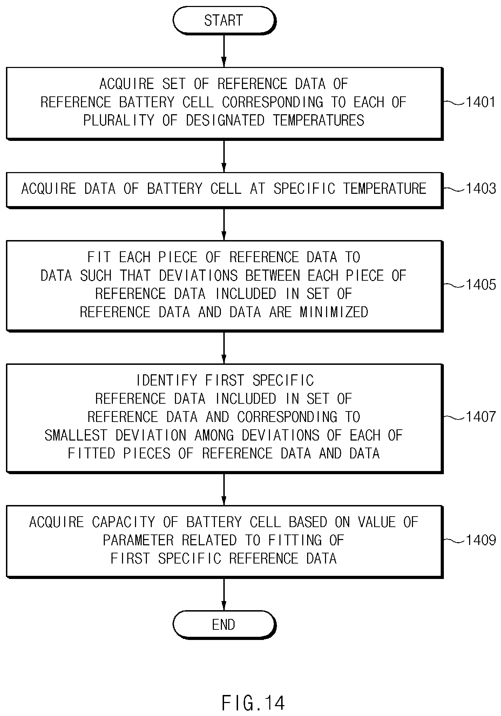

FIG. 14 illustrates an example of a flow of operations of a battery diagnostic device for identifying a capacity of a battery cell, in the battery diagnostic device and a battery diagnosis method according to an embodiment of the present disclosure.

Hereinafter, it is assumed that at least one processor 205 included in the battery diagnostic device 201 in FIG. 2 performs the process of FIG. 14. In addition, in the description of FIG. 14, it may be understood that the operations described as being performed by the battery diagnostic device 201 are controlled by at least one processor 205 included in the battery diagnostic device 201.

Hereinafter, data of the battery cell may be understood as cell data of a target battery cell. Reference data may be understood as data of a reference battery cell that serves as a reference.

Referring to FIG. 14, in a first operation 1401, at least one processor 205 according to an embodiment may acquire a set of reference data of a reference battery cell corresponding to each of a plurality of designated temperatures.

In a second operation 1403, at least one processor 205 according to an embodiment may acquire cell data of a battery cell at a specific temperature.

In a third operation 1405, at least one processor 205 according to an embodiment may fit each piece of reference data to the cell data such that deviations between each piece of reference data included in the set of reference data and the cell data are minimized.

In a fourth operation 1407, at least one processor 205 according to an embodiment may identify first specific reference data included in the set of reference data and corresponding to the smallest deviation among the deviations of each of the fitted pieces of reference data and the cell data.

In a fifth operation 1409, at least one processor 205 according to an embodiment may acquire the capacity of the battery cell based on the value of the parameter related to fitting of the first specific reference data.

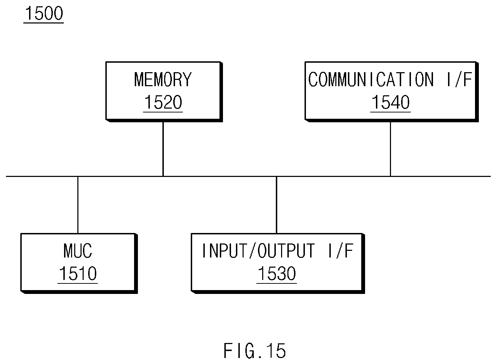

FIG. 15 is a block diagram illustrating a hardware configuration of a computing system for performing a battery diagnosis method, in a battery diagnostic device and a battery diagnosis method according to an embodiment of the present disclosure.

Referring to FIG. 15, a computing system 1500 according to an embodiment disclosed herein may include a microcontroller unit (MCU) 1510, a memory 1520, an input/output interface (I/F) 1530, and a communication I/F 1540.

The MCU 1510 may be one or more processors that executes various programs (e.g., a battery cell data collection program, a graph generation program, a data analysis program, a data decomposition algorithm, a normalization program, a battery cell diagnosis program, and the like) stored in the memory 1520, process various pieces of information including battery cell characteristic data, latent variables, and the like through the programs, and perform functions of the battery diagnostic device 201 shown in the above-described FIGS. 2 to 14.

The memory 1520 may store various programs such as the battery cell data collection program, the graph generation program, the data analysis program, the data decomposition algorithm, the normalization program, the battery cell diagnosis program, and the like.

A plurality of memories 1520 may be provided as needed. The memory 1520 may be a volatile memory or a non-volatile memory. As the volatile memory for the memory 1520, a random-access memory (RAM), a dynamic RAM (DRAM), a static RAM (SRAM), or the like may be used. As the non-volatile memory for the memory 1520, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 1520 listed above are only exemplary and are not limited to the examples.

The input/output I/F 1540 may provide an interface that connects an input device (not shown) such as a keyboard, a mouse, a touch panel, or the like, and an output device such as a display (not shown), to the MCU 1510 to enable data transmission and reception.

The communication I/F 1540 is a component that may transmit and receive various data to and from the server, and may be any device that may support wired or wireless communication. For example, the battery diagnostic device 201 may transmit and receive various types of information, including a shape model of a battery cell or the like, to and from a separately provided external server through the communication I/F 1540.

By being recorded in the memory 1520 and processed by the MCU 1510 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

## Claims

1. A battery diagnostic device comprising:
a memory storing at least one instruction; and
at least one processor executing the at least one instruction,
wherein the at least one processor is configured to:
acquire a set of reference data of a reference battery cell corresponding to each of a plurality of designated temperatures;
acquire cell data of a battery cell at a specific temperature;
fit each piece of reference data to the cell data such that deviations between each of the pieces of reference data included in the set of reference data and the cell data are minimized;
identify first specific reference data included in the set of reference data and corresponding to a smallest deviation among deviations between each of the fitted pieces of reference data and the cell data; and
diagnose a state of the battery cell based on a temperature corresponding to the first specific reference data corresponding to the smallest deviation among the plurality of designated temperatures.

2. The battery diagnostic device of claim 1, wherein the at least one processor is configured to:
divide the cell data into a plurality of sections;
identify section data included in at least a portion of the cell data and included in any one of the plurality of sections;
fit each piece of reference data to the section data such that deviations between each of the pieces of reference data and the section data are minimized;
identify second specific reference data included in the set of reference data and corresponding to a smallest deviation among the deviations between each of the fitted pieces of reference data and the section data; and
identify a temperature of the battery cell in the section based on a temperature at which the second specific reference data is acquired among the plurality of designated temperatures.

3. The battery diagnostic device of claim 1, wherein the at least one processor is configured to acquire the cell data of the battery cell in an activation process of the battery cell.

4. The battery diagnostic device of claim 1, wherein the at least one processor is configured to:
identify, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures; and
identify, based on the first reference data and the second reference data, the set of reference data corresponding to each of the plurality of designated temperatures.

5. The battery diagnostic device of claim 4, wherein the at least one processor is configured to:
identify a portion of the set of reference data corresponding to each of temperatures higher than the first temperature and lower than the second temperature among the plurality of designated temperatures by interpolating the first reference data and the second reference data; and
identify the set of reference data based on the portion of the set of reference data, the first reference data, and the second reference data.

6. The battery diagnostic device of claim 1, wherein each piece of reference data includes a capacity profile of the reference battery cell and a voltage profile of the reference battery cell, and
the at least one processor is configured to fit each piece of reference data to the cell data by performing, on the capacity profile or the voltage profile, at least one of a calculation of a specific first value, an addition of a specific second value, or any combination thereof.

7. The battery diagnostic device of claim 1, wherein the cell data includes:
a capacity profile of the battery cell included in a specified capacity range; and
a voltage profile of the battery cell according to the capacity profile.

8. The battery diagnostic device of claim 1, wherein each of the deviations between each of the pieces of reference data and the cell data includes a root mean squared error (RMSE) between each of the pieces of reference data and the cell data.

9. The battery diagnostic device of claim 1, wherein the at least one processor is configured to identify the specific temperature based on a temperature corresponding to the first specific reference data, among the plurality of designated temperatures.

10. A battery diagnostic device comprising:
a memory storing at least one instruction; and
at least one processor executing the at least one instruction,
wherein the at least one processor is configured to:
acquire a set of reference data of a reference battery cell corresponding to each of a plurality of designated temperatures;
acquire cell data of a battery cell at a specific temperature;
fit each piece of reference data to the cell data such that deviations between each of the pieces of reference data included in the set of reference data and the cell data are minimized;
identify first specific reference data included in the set of reference data and corresponding to a smallest deviation among deviations between each of the fitted pieces of reference data and the cell data; and
diagnose a state of the battery cell based on a value of a parameter related to fitting of the first specific reference data.

11. The battery diagnostic device of claim 10, wherein each piece of reference data includes a capacity profile of the reference battery cell and a voltage profile of the reference battery cell, and
the at least one processor is configured to fit each piece of reference data to the cell data by performing, on the capacity profile or the voltage profile, at least one of a calculation of a specific first value, an addition of a specific second value, or any combination thereof.

12. The battery diagnostic device of claim 11, wherein the at least one processor is configured to identify the value of the parameter based on the first value.

13. The battery diagnostic device of claim 10, wherein the at least one processor is configured to:
identify, before acquiring the set of reference data, first reference data of the reference battery cell acquired at a first temperature that is the lowest among the plurality of designated temperatures, and second reference data of the reference battery cell acquired at a second temperature that is the highest among the plurality of designated temperatures; and
identify, based on the first reference data and the second reference data, the set of reference data corresponding to each of the plurality of designated temperatures.

14. The battery diagnostic device of claim 13, wherein the at least one processor is configured to:
identify a portion of the set of reference data corresponding to each of temperatures higher than the first temperature and lower than the second temperature among the plurality of designated temperatures by interpolating the first reference data and the second reference data; and
identify the set of reference data based on the portion of the set of reference data, the first reference data, and the second reference data.

15. The battery diagnostic device of claim 12, wherein the first value related to the value of the parameter and a capacity of the battery cell are configured to have a positive correlation.

16. The battery diagnostic device of claim 10, wherein the cell data includes:
a capacity profile of the battery cell included in a specified capacity range; and
a voltage profile of the battery cell according to the capacity profile.

17. The battery diagnostic device of claim 10, wherein the reference data is acquired while the reference battery cell is being charged at a specified rate, or is acquired while the reference battery cell is being discharged, and
the cell data is acquired while the battery cell is being charged at the specified rate, or is acquired while the battery cell is being discharged.

18. The battery diagnostic device of claim 10, wherein the at least one processor is configured to acquire a capacity of the battery cell based on a value of a parameter related to fitting of the first specific reference data.

19. The battery diagnostic device of claim 18, wherein the at least one processor is configured to identify the capacity of the battery cell output from a learning model based on inputting the value of the parameter into the learning model trained to learn a correlation between the parameter and the capacity of the battery cell.
